Europäisches Patentamt

European Patent Office

Office européen des brevets

(11) Numéro de publication : **0 362 045 B1**

(12) **FASCICULE DE BREVET EUROPEEN**

(45) Date de publication du fascicule du brevet :
**23.12.92 Bulletin 92/52**

(21) Numéro de dépôt : **89402625.1**

(22) Date de dépôt : **26.09.89**

(51) Int. Cl.⁵ : **B23K 26/00**

(54) **Procédé de soudure par faisceau laser de deux pièces métalliques, et boîtier électronique soudé par ce procédé.**

(30) Priorité : **30.09.88 FR 8812800**

(43) Date de publication de la demande :
**04.04.90 Bulletin 90/14**

(45) Mention de la délivrance du brevet :
**23.12.92 Bulletin 92/52**

(84) Etats contractants désignés :
**DE GB NL SE**

(56) Documents cités :
**EP-A- 0 278 643**
**PATENT ABSTRACTS OF JAPAN vol. 9, no.**
**279 (M-427)(2002) 07 novembre 1985, & JP-**
**A-60 121093 (MITSUBISHI JUKOGYO K.K.)**
**28juin 1985**

(73) Titulaire : **THOMSON HYBRIDES**
**51, Esplanade du Général de Gaulle**
**F-92800 Puteaux (FR)**

(72) Inventeur : **Fouche, Alain**
**THOMSON-CSF SCPI Cédex 67**
**F-92045 Paris la Défense (FR)**
Inventeur : **Malbe, Serge**
**THOMSON-CSF SCPI Cédex 67**
**F-92045 Paris la Défense (FR)**

(74) Mandataire : **Taboureau, James et al**
**THOMSON-CSF SCPI B.P. 329**
**F-92402 COURBEVOIE CEDEX (FR)**

## Description

La présente invention concerne un procédé de soudure de deux pièces métalliques par faisceau laser, lorsque les pièces présentent entre elles un jeu mécanique nécessaire à leur assemblage.

La soudure par faisceau laser est un procédé couramment utilisé et qui donne d'excellents résultats si le laser est suffisamment puissant et si les pièces sont jointives et propres. Ce procédé est utilisé par exemple pour souder le couvercle posé sur un boîtier d'encapsulation de composants semiconducteurs. Les composants peuvent être sensibles à la chaleur, ce qui élimine le chauffage pour faire fondre une préforme de soudure, mais cependant ils doivent être enfermés dans des enceintes étanches pour assurer leur protection. La soudure par faisceau laser est alors un procédé commode si le couvercle, posé sur le boîtier, est jointif : un tir laser parallèle au plan du couvercle et dans le plan du joint assure une soudure parfaite et étanche.

Mais dans certaines configurations, il peut y avoir un jeu mécanique entre les deux pièces à souder. Par exemple si le couvercle d'un boîtier est encastré dans les côtés rainurés de ce boîtier. La précision d'usinage des pièces fait qu'il y a un faible jeu entre les pièces, nécessaire pour pouvoir manipuler les pièces avant leur soudure définitive. L'expérience montre que dans ce cas, si le tir laser est dans le plan du joint, il y a toujours des défauts de soudure, et des fuites, en particulier dans les angles.

Le procédé de soudure par faisceau laser de deux pièces présentant un jeu entre elles consiste à effectuer deux tirs lasers successifs. Un premier tir effectué hors du plan de joint, fait fondre l'une des deux pièces, localement, et l'effondrement de la matière fondue met en contact les deux pièces, et supprime le jeu à l'endroit du cordon de matière effondrée. Un second tir, effectué lui aussi hors du plan de joint mais plus rapproché du plan de joint que le premier tir, effectue la soudure entre les deux pièces qui ne présentent plus de jeu entre elles.

De façon plus précise, l'invention concerne un procédé de soudure par faisceau laser de deux pièces métalliques présentant un jeu mécanique entre leurs deux faces latérales en regard à souder, caractérisé en ce qu'il comporte un double tir de faisceau laser :

a) - par un premier tir laser, effectué avec un premier retrait par rapport à une face latérale d'une pièce, le métal de ladite pièce est partiellement fondu, s'effondre en annulant le jeu, et entre en contact avec le métal de l'autre pièce,

b) - un second tir laser, effectué avec un second retrait inférieur au premier retrait par rapport à la même face latérale, fait fondre le métal des deux pièces, et forme un joint de soudure.

L'invention sera mieux comprise par l'explication plus détaillée qui suit maintenant d'un exemple d'application, exposée en conjonction avec les figures jointes en annexe, qui représentent :

- figure 1 : vue de trois quarts dans l'espace, partiellement arrachée, d'un boîtier métallique dont le couvercle présente un jeu avec les côtés du boîtier,
- figure 2 : vue partielle de la région de soudure, après le premier tir de faisceau laser du procédé selon l'invention,
- figure 3 : vue de la même région qu'en figure 2, après le second tir de faisceau laser.

De façon a être plus clairement exposée, l'invention sera décrite en s'appuyant sur le cas concret d'un boîtier en aluminium ou alliage d'aluminium, dont le couvercle s'encastre dans une rainure pratiquée dans les côtés de l'embase, mais il est évident que ceci ne limite pas la portée de l'invention qui s'applique à la soudure de deux pièces métalliques qui, par nécessité, présentent un léger jeu mécanique, et ceci quel qu'en soit le métal : cuivre, acier ou autres.

De même, par commodité, les dimensions relatives des dessins sont adaptées pour plus de clarté.

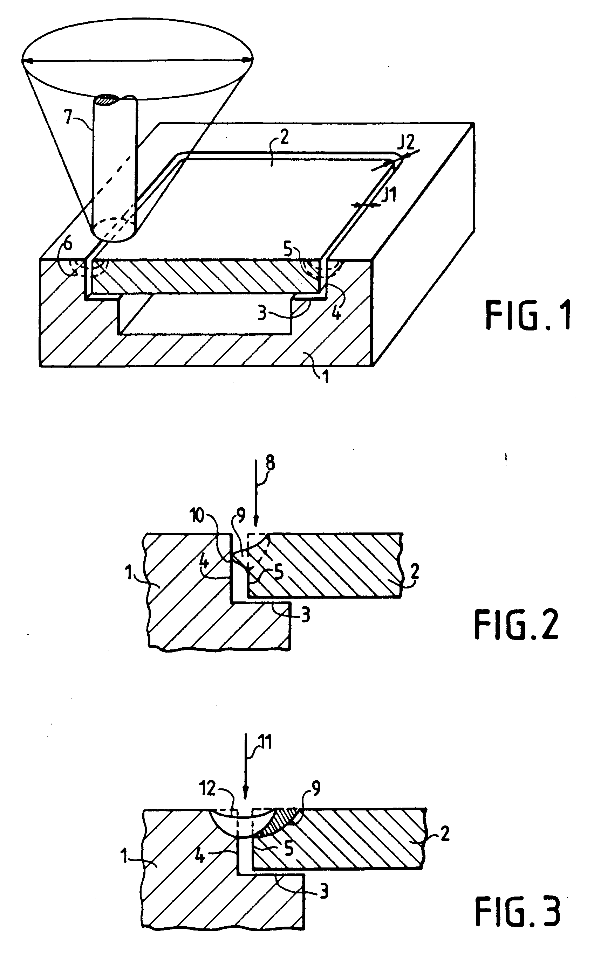

La figure 1 représente une vue, coupée pour en montrer la structure, d'un boîtier formé par une embase 1 sur laquelle un couvercle 2 doit être soudé. Les côtés de l'embase 1 comportent une rainure qui a une surface horizontale 3 et une surface verticale 4 - par rapport au plan général du boîtier supposé lui-même horizontal -.

Le couvercle 2 est délimité sur son pourtour par une surface verticale 5, qui vient en regard de la surface verticale 4 du boîtier. Ce sont ces deux surfaces 4 et 5 qui doivent être soudées par faisceau laser, mais il existe entre elles un jeu mécanique noté J1 qui a deux raisons d'être :

- il faut pouvoir mettre en place le couvercle dans son boîtier, sans avoir recours à l'insertion en force, et éventuellement le retirer, avant la fermeture définitive par soudure,
- la précision de l'usinage. A titre d'exemple, les cotes du boîtiers sont X (+ 0,1, + 0,05 mm) et les cotes du couvercle sont Y (0, - 0,05 mm). Le jeu est donc au mieux de 0,05 mm et au pire de 0,15 mm.

Mais de plus, si le boîtier n'est pas rond, le jeu J2 dans les coins est toujours plus important : par exemple le boîtier présente dans les coins un arrondi d'usinage sur un rayon de 2 mm (0, - 0,05 mm) et le couvercle un arrondi sur un rayon de 1,8 mm (± 0,1 mm).

La soudure laser que l'on désire effectuer est représentée en 6, et un faisceau laser tel que 7, agit sur un diamètre de l'ordre de 0,8 - 1 mm, a une portée suffisante pour échauffer à la fois le boîtier et le couvercle, malgré le jeu qui les sépare.

En fait, si le tir laser est effectué de façon classique en axant le faisceau laser 7 sur le plan du joint 4-5, on observe deux choses :

- il y a toujours des imperfections de soudure, et des fuites, dans les coins, et ces imperfections ne peuvent pas être réparées, par un nouveau tir laser,

- les parties du boîtier et du couvercle fondues par le faisceau laser, se touchent mais ne se mouillent pas. Il y a parfois contact, mais il n'y a pas soudure.

Ces deux phénomènes ont la même origine : la présence d'un jeu de 0,05 à 0,35 mm entre pièces, intervalle dans lequel il y a de l'air ambiant issu de l'intérieur du boitier malgré le balayage de gaz neutre. L'énergie du faisceau laser ionise l'air, et les deux parois verticales 4 et 5, en face à face, sont oxydées en surface. De sorte que le faisceau laser forme deux demi-cordons de matière fondue, séparés par une double couche d'oxyde de métal constitutif du boîtier et du couvercle.

Le procédé selon l'invention consiste à d'abord amener le métal d'une pièce au contact avec le métal de l'autre pièce, de façon à supprimer le jeu - si faible soit-il, et nécessaire à l'assemblage du boîtier complet - et à obtenir la mouillabilité réciproque des deux pièces, par suppression de l'air compris entre les pièces au niveau de la soudure et des couches d'oxydes. Ensuite, la soudure est effectuée, et elle ne présente pas de défauts.

La figure 2 représente la première étape du procédé. Soit 1 l'élément de boîtier dans lequel est encastré un couvercle 2, avec un léger jeu entre les faces latérales en regard 4 et 5. Le couvercle repose sur la face 3 de la rainure dans le boîtier, et il est pointé en quelques endroits pour éviter sa déformation pendant le soudage.

Un premier tir de laser, symbolisé par une flèche 8, est effectué avec un premier retrait par rapport à l'arête d'une pièce : par exemple, en figure 2, le tir est effectué avec un retrait de 3/10 mm par rapport à l'arête de la face 4 de l'élément du boitier 1, mais le tir aurait pu également viser le couvercle 2. Il en résulte pour la première pièce un effondrement de matière 9, qui vient en contact en 10 avec la deuxième pièce. Le long du ruban de contact 10, il n'y a plus d'air entre les deux pièces donc il n'y aura pas formation d'oxyde.

De façon plus précise, si le faisceau laser a un rayon de 0,4 mm, si le retrait est de 0,3 mm et si le jeu est de 0,05 à 0,15 mm, la deuxième pièce, c'est-à-dire le boîtier 1, est également légèrement fondu sur sa face 4, mais cela ne modifie pas l'exposé du procédé : le premier tir concerne essentiellement l'une des deux pièces à souder.

Dans un deuxième temps, représenté en figure 3, un deuxième tir de faisceau laser 11, effectué avec un second retrait par rapport à l'arête de la première pièce, forme un joint de soudure 12.

Le second retrait est moins important que le premier retrait : de l'ordre de 0,1 mm dans l'exemple cité, de sorte qu'au cours du second tir le faisceau laser échauffe et fait fondre le métal des deux pièces à souder, qui se mouillent réciproquement puisqu'il n'y a plus formation de films d'oxydes.

Le second cône 12 de matière fondue est décalé par rapport au premier cône 9, puisque les deux tirs lasers sont décalés : les coupes micrographiques sur pièces soudées par le procédé selon l'invention montrent clairement les deux cônes de refusions successives.

Le procédé est employé plus particulièrement pour la fermeture étanche de boîtiers en électronique hyperfréquences.

## Revendications

1. Procédé de soudure par faisceau laser de deux pièces métalliques (1, 2) présentant un jeu mécanique entre leurs deux faces latérales (4, 5) en regard à souder, caractérisé en ce qu'il comporte un double tir de faisceau laser :

   a) - par un premier tir laser (8), effectué avec un premier retrait par rapport à une face latérale (4) d'une pièce (1), le métal de l'autre pièce (2) est partiellement fondu (9), s'effondre en annulant le jeu, et met en contact (10) les deux pièces (1, 2),

   b) - un second tir laser (11), effectué avec un second retrait inférieur au premier retrait par rapport à la même face latérale (4), fait fondre le métal des deux pièces (1,2), et forme un joint de soudure (12).

2. Procédé de soudure selon la revendication 1, caractérisé en ce que le premier tir laser (8), en amenant le métal (9) de la première pièce (2) au contact (10) avec le métal de la deuxième pièce (1), élimine l'air entre lesdites pièces (1, 2) et permet leur mouillabilité au cours du second tir laser (11).

## Patentansprüche

1. Verfahren zum Verschweißen zweier metallischer Bauteile (1, 2), die ein mechanisches Spiel zwischen ihren beiden gegenüberliegenden und zu verschweißenden Seitenflächen (4, 5) besitzen, mit Hilfe eines Laserstrahls, dadurch gekennzeichnet, daß das Verfahren zwei Laserstrahlschüsse umfaßt, nämlich
a) einen ersten Laserschuß (8), der mit einer ersten Verschiebung bezüglich einer Seitenfläche (4) eines der Bauteile (1) erfolgt und bei dem das Metall des anderen Bauteils (2) teilweise schmilzt (9), unter Überbrückung des Spiels zerfließt und die beiden Bauteile (1, 2) in Kontakt (10) bringt,

b) einen zweiten Laserschuß (11), der mit einer zweiten Verschiebung erfolgt, die geringer als die erste Verschiebung bezüglich derselben Seitenfläche (4) ist und das Metall der beiden Bauteile (1, 2) zum Schmelzen bringt und eine Schweißnaht (12) bildet.

2. Schweißverfahren nach Anspruch 1, dadurch gekennzeichnet, daß der erste Laserschuß (8), indem er das Metall (8) des ersten Bauteils (2) in Kontakt (10) mit dem Metall des zweiten Bauteils (1) bringt, die Luft zwischen diesen beiden Bauteilen (1, 2) eliminiert und die Benetzbarkeit während des zweiten Laserschusses (11) zuläßt.

**Claims**

1. A welding process, by laser beam, of two metallic pieces (1,2) having a mechanical play between their two lateral opposite faces (4,5) which are to be welded, characterised in that it comprises a double firing of the laser beam:
   a) - by a first laser firing (8), carried out with a first retreat with respect to a lateral face (4) of a piece (1), the metal of the other piece (2) is partially melted (9), giving way by cancelling the play, and puts into contact (10) the two pieces (1,2),
   b) - a second laser firing (11), carried out with a second retreat, lower than the first retreat with respect to the same lateral face (4), melting the metal of the two pieces (1,2), and forms a welding joint (12).

2. A welding process according to Claim 1, characterised in that the first laser firing (8), bringing the metal (9) of the first piece (2) in contact (10) with the metal of the second piece (1), eliminates the air between the said pieces (1,2) and permits their wettability during the second laser firing (11).

FIG.1

FIG.2

FIG.3